# EUROPEAN PATENT SPECIFICATION

(11) **EP 1 367 643 B1**
(45) Date of publication and mention of the grant of the patent: **05.04.2006**
(21) Application number: 03010033.3
(22) Date of filing: 02.05.2003
(51) Int. Cl.: H01L 23/48, H01L 25/07

(54) **Electronic module**
Elektronikmodul
Module électronique

(30) Priority: 15.05.2002 EP 02010787
(43) Date of publication of application: 03.12.2003
(73) Proprietor: Tyco Electronics AMP GmbH, 64625 Bensheim (DE)
(72) Inventor: Ehler, Ralf, 1025 Budapest (HU); Frisch, Michael, 81379 München (DE)
(74) Representative: Patentanwaltskanzlei WILHELM & BECK

(56) References cited:
- EP-A- 1 198 001
- EP-A- 1 209 742
- US-A- 4 607 276
- US-B1- 6 265 765
- US-B1- 6 378 758

## Description

The invention relates to an electronic module with a semiconductor.

To achieve continuous disturbance-free operation of a semiconductor, there must be reliable electrical contact and adequate heat dissipation. Reliable electrical contact is important, because a specific current flux dependent upon corresponding electrical contact of a semiconductor is required to operate a semiconductor in an electronic module. To further maintain operability, there must be adequate heat dissipation of heating that occurs during operation of the semiconductor due to heat loss.

In power semiconductors, for example, where current can assume very high operation values, heat loss can be very high and it is often difficult to achieve reliable electrical contacting and adequate heat dissipation. Many methods for electrically contacting semiconductor chips are already known. For example, in "wire bonding" a lower side of the chip is fastened to a substrate and an upper side of the chip is electrically contacted by welded-on wires. In "tape automated bonding" (TAB) the chip is connected at a plurality of points to a printed conductor structure via contact humps, with simultaneous pressure and heat. In the "flip-chip method" the chip is connected to the substrate with pressure and heat via contact humps with an active side facing the substrate. Also known are various adhesion methods and other contacting methods, some of which have been developed for special applications.

The prior right EP 1 209 742 A1 discloses a spring arrangement for a high performance semiconductor module, wherein an electric contact between the semiconductor and a cover is accomplished by a spring, and a pre-stressing of the cover and a housing is accomplished by a separate second spring.

The US 6 265 765 B1 discloses,a semiconductor chip assembly, wherein a chip and a package element such as a heat sink are connected by flexible leads between each contact of the chip and each terminal on the package element.

The US 4 607 276 discloses an electronic component disposed between a base component and a cover component, wherein a resilient tape lead frame is bonded between the base component and the cover component.

The EP 1 198 001 A2 discloses a semiconductor bonded within a cavity of a ceramic package, wherein the ceramic package comprises a plurality of resilient S-shaped contact structures with which the ceramic package is mounted for example at conductive lead frame fingers of a lead frame.

Despite the large number of known methods of contacting, there is still a need to improve the contacting of semiconductors of an electronic module, in particular power semiconductors, to ensure disruption-free operation of the electronic module over a period as long as possible. Moreover, the production costs in known contacting methods are sometimes very high and make economical manufacture difficult. It is therefore desirable to develop an electronic module with a semiconductor that has reliable electrical contacting and low manufacturing costs.

The invention relates to an electronic module that has a semiconductor arranged on a substrate. The semiconductor has an electrically conductive contact face on a side remote from the substrate. A contacting unit is configured to be at least partially elastically yielding. A support element at the contacting unit is configured to press the contacting unit toward the substrate to make electrical contact. The contacting unit contacts the substrate and/or the contact face with a contact tongue. The contact tongue and the support element extend to opposite sides from the contacting unit and are provided integrally therewith.

The invention will be described in greater detail hereafter with reference to the drawings, in which:
Fig. 1 is a perspective view of an embodiment of an electronic module according to the invention; and
Fig. 2 is a vertical sectional view taken along a longitudinal side of the electronic module of Fig. 1.

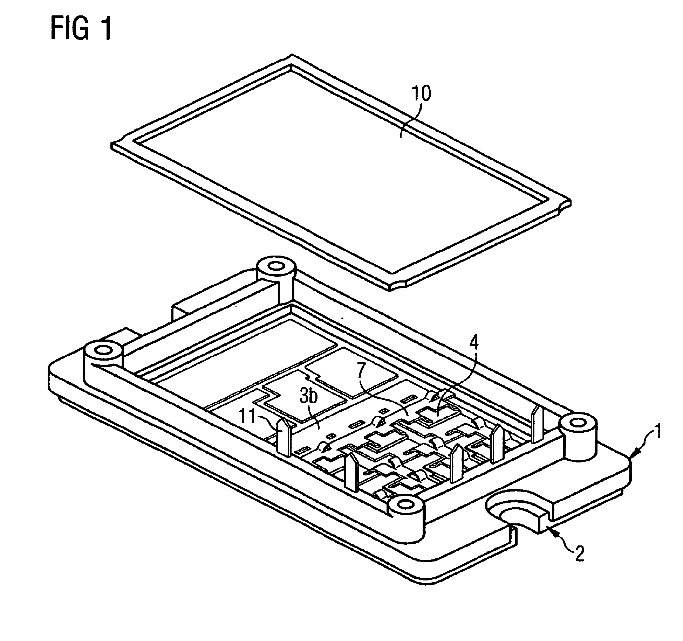

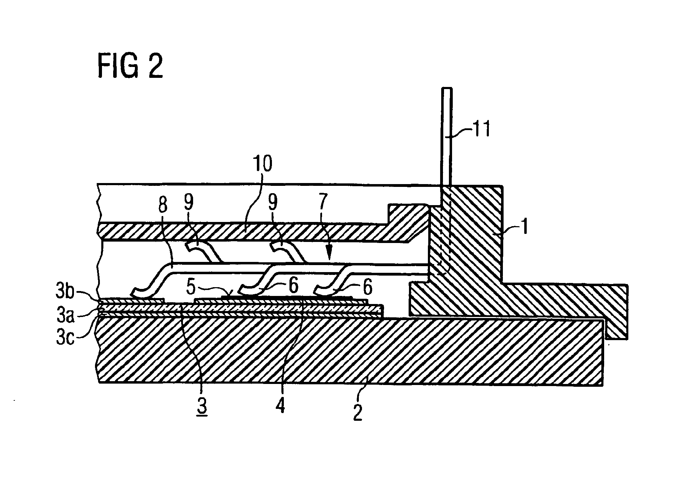

Figures 1 and 2 show an electronic module, such as a power module having a three-phase bridge rectifier constructed by a vertical method. The electronic module has a housing 1. The housing 1 is provided to protect sensitive electronics contained therein from external influences, such as mechanical effects or soiling. A substrate 3 is arranged on a base plate 2 of the housing 1. The substrate 3 may be a copper-coated ceramic having a copper layer 3b, 3c applied to either side of ceramic carrier 3a. The copper layers 3b, 3c are formed to correspond to the desired wiring of the electronic module to form printed conductors. The copper layers 3b, 3c are also optionally through-hole plated.

As best shown in Figure 2, a plurality of semiconductors 4 are arranged on the substrate 3. The semiconductors 4 are respectively connected to the substrate 3 on a lower side facing the substrate 3, for example, by adhesive or soldering, such that there is optimal electrical and thermal contact between the substrate 3 and the semiconductors 4. Upper sides of the semiconductors 4 (the sides remote from the substrate 3) may be formed as contact faces 5.

Contact units 7 have a plurality of contact tongues 6 extending therefrom. The contacting tongues 6 rest on the contact faces 5 to electrically connect the semiconductor 4 to the corresponding contacting unit 7. The contacting units 7 are each configured as a sheet-metal part with a flat central piece 8. The sheet-metal part may, for example, be a copper/beryllium alloy. The contacting unit 7 may be formed as a stamping, a cut part or as an etched part. The contact tongues 6 are configured in one piece with the central piece 8. The contact tongues 6 are formed as narrow strips which are partially stamped free from the central piece 8 and project obliquely from a main plane of the central piece 8. Ends of the contact tongues 6 are bent in such a way that the ends are oriented approximately parallel to the main plane of the central piece 8. In the embodiment shown, each contacting unit 7 has two mutually parallel rows of the contact tongues 6. Between the two mutually parallel rows of the contact tongues 6, support elements 9 project obliquely from the main plane of the central piece 8 on a side opposite from the contact tongues 6 of the central piece 8. The support elements 9 are formed by free stamping and have a similiar form as the contact tongues 6.

The contact tongues 6 and the support elements 9 are configured such that the contact tongues 6 and the support elements 9 elastically flex inward toward the main plane of the central piece 8 when the housing 1 of the electronic module is sealed by a cover 10 that supports the support elements 9. Once flexed inward, the contact tongues 6 and the support elements 9 try to resile to their original position causing the contact tongues 6 to be pressed against the contact faces 5 of the semiconductors 4 or against the copper layer 3b of the substrate 3. The contacting units 7 are pressed with the contact tongues 6 against the contact faces 5 of the semiconductors 4 or against the copper layer 3b of the substrate 3 and, therefore, are simultaneously fixed with respect to their lateral position. To facilitate positioning of the contacting units 7 in the electronic module, recesses (not shown) may be formed at an edge of the housing 1 for receiving the contacting units 7. The recesses (not shown), in co-operation with the cover 10, fixedly position the contacting units 7 to eliminate subsequent slipping of the contacting units 7 after fitting of the cover 10.

External connections of the electronic module may be produced by an external contact lug 11 provided on each of the contacting units 7. The external contact lug 11 is configured as a strip-like extension of the central piece 8. In the embodiment shown, the external contact lugs 11 are each angled to be closed by the cover 10 on a side of the housing 1 and protrude from the housing 1 such that the contact lugs 11 are accessible from an outside of the housing 1. Alternatively, the external contact lugs 11 may be configured in such a way that a contact may be produced by a screwed connection.

In the electronic module described herein, it is easy to make contact with the contact faces 5 of the semiconductors 4. Because of the elastic inward flexing of the contact tongues 6 and the support elements 9, the contact tongues 6 are pressed with a defined pressing force against the contact faces 5 of the semiconductors 4 such that reliable contact is maintained under changing mechanical and thermal conditions. Alternatively, electrically conductive connections between the semiconductors 4 and the various contact faces 5 of the semiconductor 4 may be produced by the central piece 8. Because the contact tongues 6 also rest on the substrate 3 (copper layer 3b), electrically conductive connections to the substrate 3 and to the lower sides of the semiconductors 4 may still be produced. The contacting units 7, in addition to the copper layers 3b, 3c of the substrate 3, therefore, also function as printed conductors.

The contact element 6 and/or the support element 9 preferably each project obliquely from the main plane of the contacting unit 7 and are angled in their end region. This has the advantage that the elastic yielding capacity of the contacting unit 7 is produced by a very simple geometry and in that protective contacting over a large area is possible owing to the angled end regions and allows a high current throughput.

This type of contacting of the semiconductor 4 has the advantage that the costs for producing an electrically conductive connection to the semiconductor 4 are extremely low, as no expensive automatic soldering machines or similarly complex special machines are required. In addition, the electrically conductive connection produced in this way is distinguished by an extremely long service life and in particular by load change resistance and temperature change resistance. This is because there is no integral connection between the contacting unit 7 and the contact face 5 of the semiconductor 4 which would be heavily stressed especially in constantly changing conditions. Instead, mechanical effects and changes of shape caused by thermal expansion can be compensated by the possibility of a relative movement between the contacting unit 7 and the contact face 5 of the semiconductor 4 and/or by elastic deformation of the contacting unit 7. A further advantage is that damage to the semiconductor 4 by the contacting process can be virtually ruled out as mechanical effects on the semiconductor 4 occurring during the contacting process are cushioned by the yielding capacity of the contacting unit 7. Finally, it is also advantageous that an insert of environmentally detrimental materials can be dispensed with during contacting. The contacting unit 7 may rest on at least one contact face 5 of the same semiconductor 4. The contacting unit 7 may also rest on at least one contact face 5 of at least one further semiconductor 4 of the electronic module. Finally, the contacting unit 7 may also rest on the substrate 3. Therefore, the most varied contacting wishes can be met without design changes, so the particular circumstances, in each case, of the respective application can be allowed for. Moreover the number of contacting units 7 required per electronic module may be kept low so assembly costs are not very high.

Moreover, at least one contacting unit 7 generally has one connection element for producing an external connection to the electronic module. Because external connections do not need to be specially produced, cost is reduced. The reliability of the external connections is also increased, since the connection elements are each formed in one piece with the associated contacting unit 7.

The electronic module may comprise at least one positioning aid for the correctly positioned arrangement of at least one contacting unit 7. In particular, the positioning aid may be configured as at least one recess in the housing 1. This has the advantage that the contacting unit 7 can be arranged simply and precisely, in each case, in the electronic module. The positioning aid may also serve, in an advantageous manner, to permanently fix the contacting unit 7 in the electronic module and therefore prevent accidental displacement of the contacting unit 7.

The contacting unit 7 may be formed as a one-piece sheet metal part. A sheet-metal part is, on the one hand, economical to produce and, on the other hand, can be machined very easily and diversely, stamping processes in particular being available for machining as these can be carried out quickly and economically. The contacting unit 7 is preferably formed as a stamping for this reason. Further advantages of a sheet-metal part are the robustness and long service life thereof and the plurality of available materials which allow optimisation of the material properties for the respective application. In addition, the entire cross-section of the contacting unit 7 is available for electrical conductivity when using a sheet-metal part. An other embodiment of the invention is, for example, to further facilitate the manufacture of the electronic module, that the contacting units 7 may be configured as a lead frame. Additionally, the support elements 9 may be dispensed with or replaced by rigid elements, and the base plate 2 of the housing 1 may be eliminated.

## Claims

1. An electronic module, comprising:
a semiconductor (4) arranged on a substrate (3), the semiconductor (4) having an electrically conductive contact face (5) on a side remote from the substrate (3);
a contacting unit (7) configured to be at least partially elastically yielding; and
a support element (9) configured to press the contacting unit (7) towards the substrate (3) to make electrical contact with substrate and/or the contact face;
wherein the contacting unit (7) includes contact tongues (6) that extend towards the substrate (3), and includes the support element (9) extending towards a cover (10) and is supported by the cover (10), wherein the contact tongues (6) and the support element (9) are elastically yielding towards a central piece (8) of the contacting unit (7); and
wherein the contact tongues (6) and the support element (9) extend from opposite sides of the central piece (8) of the contacting unit (7).

2. The electronic module of claim 1, wherein the substrate (3) has a copper layer (3b) and the support element (9) presses the contacting unit (7) against the copper layer (3b) to make electrical contact.

3. The electronic module of claim 1 or 2, wherein the contact tongues (6) extend obliquely from the central piece (8) of the contacting unit (7).

4. The electronic module of claim 1, further comprising a housing (1) whereby, the supporting element (9) is supported by the cover (10) such that when the cover is received on the housing (1) the supporting element (9) presses the contacting unit (7) against the contact face (5).

5. The electronic module of claim 1, wherein the contact tongues (6) and the support element (9) have the same shape, respectively.

6. The electronic module of claim 1, wherein the contact tongues (6) have ends positioned parallel to the central piece (8) of the contacting unit (7).

7. The electronic module of any one of the preceding claims, wherein the contacting unit (7) is configured as a one-piece sheet metal part.

8. The electronic module of any one of the preceding claims, wherein the contacting unit (7) includes a connection element (11) to produce an external connection to the electronic module.

9. The electronic module of any one of the preceding claims, further comprising a recess in the housing (1) of the electronic module as a positioning aid for correctly positioning the contacting unit (7).

10. The electronic module of claim 1, wherein the contacting unit (7) is configured as a lead frame.

11. The electronic module of any one of the preceding claims, wherein the contacting unit (7) contacts the contact face (5).

## Patentansprüche

1. Elektronikmodul, das folgendes umfaßt:
einen auf einem Substrat (3) angeordneten Halbleiter (4), wobei der Halbleiter (4) auf einer von dem Substrat (3) entfernten Seite eine elektrisch leitfähige Kontaktfläche (5) hat,
eine kontaktgebende Einheit (7), die konfiguriert ist, um wenigstens teilweise elastisch nachgiebig zu sein, und
ein Stützelement (9), das konfiguriert ist, um die kontaktgebende Einheit (7) zum Substrat (3) hin zu drücken zum Herstellen eines elektrischen Kontakts mit dem Substrat und/oder der Kontaktfläche,
wobei die kontaktgebende Einheit (7) Kontaktzungen (6) einschließt, die sich zum Substrat (3) hin erstrecken, und das Stützelement (9) einschließt, das sich zu einer Abdeckung (10) hin erstreckt und durch die Abdeckung (10) gestützt wird, wobei die Kontaktzungen (6) und das Stützelement (9) elastisch zu einem Mittelstück (8) der kontaktgebenden Einheit (7) hin nachgeben, und
wobei sich die Kontaktzungen (6) und das Stützelement (9) von gegenüberliegenden Seiten des Mittelstücks (8) der kontaktgebenden Einheit (7) erstrecken.

2. Elektronikmodul nach Anspruch 1, wobei das Substrat (3) eine Kupferschicht (3b) hat und das Stützelement (9) die kontaktgebende Einheit (7) an die Kupferschicht (3b) drückt, um einen elektrischen Kontakt herzustellen.

3. Elektronikmodul nach Anspruch 1 oder 2, wobei sich die Kontaktzungen (6) schräg vom Mittelstück (8) der kontaktgebenden Einheit (7) aus erstrecken.

4. Elektronikmodul nach Anspruch 1, das ferner ein Gehäuse (1) umfaßt, wodurch das Stützelement (9) durch die Abdeckung (10) gestützt wird derart, daß das Stützelement (9) die kontaktgebende Einheit (7) an die Kontaktfläche (5) drückt, wenn die Abdeckung auf dem Gehäuse (1) aufgenommen wird.

5. Elektronikmodul nach Anspruch 1, wobei die Kontaktzungen (6) und das Stützelement (9) jeweils die gleiche Form haben.

6. Elektronikmodul nach Anspruch 1, wobei die Kontaktzungen (6) Enden haben, die parallel zum Mittelstück (8) der kontaktgebenden Einheit (7) angeordnet sind.

7. Elektronikmodul nach einem der vorhergehenden Ansprüche, wobei die kontaktgebende Einheit (7) als ein einteiliges Blechteil konfiguriert ist.

8. Elektronikmodul nach einem der vorhergehenden Ansprüche, wobei die kontaktgebende Einheit (7) ein Anschlußelement (11) einschließt, um einen externen Anschluß an das Elektronikmodul zu erzeugen.

9. Elektronikmodul nach einem der vorhergehenden Ansprüche, das ferner als Positionierhilfe zum richtigen Positionieren der kontaktgebenden Einheit (7) eine Aussparung im Gehäuse (1) des Elektronikmoduls umfaßt.

10. Elektronikmodul nach Anspruch 1, wobei die kontaktgebende Einheit (7) als ein Leiterrahmen konfiguriert ist.

11. Elektronikmodul nach einem der vorhergehenden Ansprüche, wobei die kontaktgebende Einheit (7) die Kontaktfläche (5) berührt.

## Revendications

1. Module électronique, comprenant :
un semi-conducteur (4) agencé sur un substrat (3), le semi-conducteur (4) comportant une face de contact électriquement conductible (5) sur un côté éloigné du substrat (3) ;
une unité d'établissement de contact (7) configurée de sorte à se prêter au moins partiellement à un fléchissement élastique ; et
un élément de support (9) destiné à presser l'unité d'établissement de contact (7) vers le substrat (3) pour établir un contact électrique avec le substrat et/ou la face de contact ;
l'unité d'établissement de contact (7) englobant des languettes de contact (6) s'étendant vers le substrat (3), et englobant l'élément de support (9) s'étendant vers un couvercle (10) et supporté par le couvercle (10), les languettes de contact (6) et l'élément de support (9) pouvant être fléchis de manière élastique vers une partie centrale (8) de l'unité d'établissement de contact (7) ; et
les languettes de contact (6) et l'élément de support (9) s'étendant à partir des côtés opposés de la partie centrale (8) de l'unité d'établissement de contact (7).

2. Module électronique selon la revendication 1, dans lequel le substrat (3) comporte une couche de cuivre (3b), l'élément de support (9) pressant l'unité d'établissement de contact (7) contre la couche de cuivre (3b) pour établir un contact électrique.

3. Module électronique selon les revendications 1 ou 2, dans lequel les languettes de contact (6) s'étendent de manière oblique à partir de la partie centrale (8) de l'unité d'établissement de contact (7).

4. Module électronique selon la revendication 1, comprenant en outre un boîtier (1), l'élément de support (9) étant ainsi supporté par le couvercle (10), de sorte que lorsque le couvercle est reçu sur le boîtier (1), l'élément de support (9) presse l'unité d'établissement de contact (7) contre la face de contact (5).

5. Module électronique selon la revendication 1, dans lequel les languettes de contact (6) et l'élément de support (9) ont respectivement la même forme.

6. Module électronique selon la revendication 1, dans lequel les languettes de contact (6) comportent des extrémités parallèles à la partie centrale (8) de l'unité d'établissement de contact (7).

7. Module électronique selon l'une quelconque des revendications précédentes, dans lequel l'unité d'établissement de contact (7) est configurée sous forme d'une partie de tôle d'une seule pièce.

8. Module électronique selon l'une quelconque des revendications précédentes, dans lequel l'unité d'établissement de contact (7) englobe un élément de connexion (11) pour établir une connexion externe avec le module électronique.

9. Module électronique selon l'une quelconque des revendications précédentes, comprenant en outre un évidement dans le boîtier (1) du module électronique, servant de moyen de positionnement pour assurer le positionnement correct de l'unité d'établissement de contact (7).

10. Module électronique selon la revendication 1, dans lequel l'unité d'établissement de contact (7) est configurée sous forme d'une grille de connexion.

11. Module électronique selon l'une quelconque des revendications précédentes, dans lequel l'unité d'établissement de contact (7) contacte la face de contact (5).
